# DEMANDE DE BREVET EUROPEEN

(11) **EP 4 358 156 A1**
(43) Date de publication de la demande: **24.04.2024**
(21) Numéro de dépôt: 23204117.8
(22) Date de dépôt: 17.10.2023
(51) Int. Cl.: H01L 31/0304, H01L 27/146, H01L 31/105

(54) **PROCÉDÉ DE FABRICATION DE PHOTODIODES À HÉTÉROJONCTIONS DURCIES AUX IRRADIATIONS**

(30) Priorité: 20.10.2022 FR 2210840
(71) Demandeur: THALES, 92190 Meudon (FR); Commissariat à l'Energie Atomique et aux Energies Alternatives, 75015 Paris (FR)
(72) Inventeur: DEMIGUEL, Stéphane, 06156 Cannes la Bocca Cedex (FR); REVERCHON, Jean-Luc, 91767 Palaiseau (FR); BENFANTE, Marco, 91300 Massy (FR)
(74) Mandataire: Atout PI Laplace

(57) **Abrégé**

La présente invention propose un procédé de fabrication d'un composant optoélectronique comprenant au moins une photodiode, les étapes du procédé permettant de déplacer le champ électrique de collection des porteurs dans la couche la moins sensible aux radiations, réduisant ainsi l'influence de l'irradiation sur le courant d'obscurité.

## Description

### Domaine Technique

La présente invention concerne le domaine des photodiodes à hétérojonctions, et plus spécifiquement, elle concerne un procédé de fabrication de telles photodiodes, de type mono-élément ou sous forme matricielle, permettant d'améliorer leur comportement face aux radiations, en particulier pour des applications spatiales.

### Etat de la technique

Les communications optiques en espace libre constituent une alternative aux solutions hyperfréquences dans des conditions de transmission de l'atmosphère adéquates. Une difficulté essentielle est celle du pointage entre une source (i.e. un émetteur) et une destination (i.e. un détecteur). Le pointage requière une poursuite opto-mécanique qui n'est pas triviale.

Les solutions de poursuite entre satellites basées sur des dispositifs opto-mécaniques permettent l'asservissement entre deux satellites même en orbites basses. La chaine de détection requiert a minima une photodiode rapide dédiée et une fonction de localisation de la source par un imageur.

Un imageur composé d'une matrice de photodiodes présente l'avantage de travailler sur un grand champ sans élément opto-mécanique de poursuite ou de positionnement. Cependant, un imageur classique limite la bande passante sur un pixel à quelques dizaines de MBps pour des raisons de limitation du bruit de lecture.

Il est connu qu'une gamme de longueur d'onde privilégiée est l'infrarouge qui bénéficie d'une plus faible diffusion par les aérosols. La gamme proche infrarouge permet de bénéficier du développement de composants pour l'optique fibrée pour les télécommunications jusqu'à des longueurs d'onde de 1,65 µm.

Les matériaux InGaAs, i.e. l'arséniure d'indium et de gallium qui est un alliage d'arséniure d'indium et d'arséniure de gallium, sur substrat InP sont des matériaux de choix pour les composants des communications optiques en espace libre. L'arséniure de gallium peut convertir efficacement l'électricité en lumière cohérente, et les composants privilégient les longueurs d'ondes au-delà de 1,3 µm, en particulier 1,55 µm qui est une longueur d'ondes de bons nombres de sources existantes commercialement.

Ces matériaux peuvent être aussi utilisés pour des composants sous forme matricielle dans des instruments d'observation visant une bande SWIR (« Short Wave Infra-Red » en anglais) réduite, coupant à 1.65 µm.

Cependant, il a été trouvé que les détecteurs en format mono-éléments ou matriciel, basés sur les matériaux InGaAs ont une très grande fragilité à l'égard de l'irradiation lors des missions spatiales. De nombreuses études ont montré une augmentation du courant d'obscurité et la présence de bruit de télégraphiste, i.e. une augmentation intempestive du niveau de courant d'obscurité.

En effet, la technologie InGaAs présente une sensibilité aux irradiations, qui est exacerbée par le champ électrique présent dans la zone active de la structure.

Aussi, les solutions existantes, basées sur des matrices de photodiodes PIN (pour « Positive Intrinsic Négative » selon l'anglicisme consacré) et présentant un champ électrique interne dans le matériau absorbant InGaAs, ont l'inconvénient majeur d'avoir une sensibilité à l'irradiation du fait que le matériau de plus petite largeur de bande interdite (« bandgap » en anglais) est le plus sensible.

Il existe alors un besoin pour des photodiodes, mono-éléments ou matricielles, qui présentent une sensibilité réduite aux irradiations, dans le but de diminuer le courant d'obscurité.

Il existe en particulier un besoin pour des structures fabriquées avec des matériaux de type III-V, comme par exemple les semi-conducteurs InGaAs sur substrat InP (i.e. le Phosphure d'indium qui est un semi-conducteur binaire de type III-V), utilisant aussi des matériaux ternaires ou quaternaires InAIAs/InGaAsP, et dans lesquelles le champ électrique se situe en dehors de la zone d'absorption InGaAs.

De telles structures doivent permettre leur utilisation pour des communications optiques et pour de l'observation dans les applications spatiales.

La présente invention répond à ces besoins.

### Résumé de l'invention

Un objet de la présente invention est un procédé de fabrication de composant optoélectronique comprenant au moins une photodiode.

Avantageusement, le procédé de l'invention permet de placer le champ électrique de collection des porteurs dans la couche la moins sensible aux radiations, réduisant ainsi l'influence de l'irradiation sur le courant d'obscurité.

Le procédé de l'invention peut être utilisé pour produire des matrices de photodiodes pour des instruments d'observation visant une bande SWIR (« Short Wave Infra-Red » en anglais) réduite, coupant à 1.65 µm, au lieu de couper classiquement à 2.5 µm.

Plus généralement, le procédé de l'invention peut être étendu sans modifications majeures à l'ensemble de la bande, seule la zone active et certaines couches d'adaptation doivent être modifiées au premier ordre, au moyen d'un alliage InGaAsSb sur substrat GaSb ou de super-réseau de la famille InGaAs / GaAsSb sur substrat InP.

Le procédé de l'invention permet de fabriquer des composants moins sensibles aux irradiations dans des matériaux semi-conducteurs de type III-V, en particulier le matériau InGaAs qui présente l'avantage de fonctionner à des températures non cryogéniques, contrairement au matériau HgCdTe usuellement utilisé pour les applications spatiales.

Pour obtenir les résultats recherchés, il est proposé un procédé de fabrication d'un composant optoélectronique comprenant au moins une photodiode, le procédé comprenant au moins des étapes consistant à :
- réaliser (1702) à partir d'un substrat semi-conducteur dopé p au moins sur sa partie supérieure, plusieurs croissances épitaxiales pour obtenir un empilement de couches semi-conductrices, l'empilement étant composé au-dessus du substrat (102), d'une couche d'absorption (104) dans un matériau dopé p, puis d'une couche pour collecter des électrons (106) faiblement dopée et de grande bande interdite, et d'une couche barrière de surface (108-1, 108-2) de grande bande interdite ; et
- réaliser (1704) une pixellisation à base de dopage de type n au niveau de la couche barrière de surface, la pixellisation comprenant des métallisations (1706) pour créer des contacts électriques (112, 118) pour ladite au moins une photodiode, d'une part sur la couche barrière de surface pixellisée dopée n, et d'autre part sur la partie supérieure dopée p du substrat semi-conducteur.

L'invention propose plusieurs modes de réalisation.

Selon un aspect particulier de l'invention, l'étape de réaliser une couche d'absorption comprend une étape de dopage uniforme ou gradué de type p du matériau de ladite couche d'absorption.

Selon un aspect particulier de l'invention, l'étape de réaliser une couche pour collecter des électrons (106) consiste à réaliser une zone collecteur si ladite au moins une photodiode est une photodiode UTC.

Selon un aspect particulier de l'invention, l'étape de réaliser une couche pour collecter des électrons (106) consiste à réaliser une zone avalanche si ladite au moins une photodiode est une photodiode APD.

Selon un aspect particulier de l'invention, l'étape de réaliser une couche barrière de surface de grande bande interdite consiste en une croissance épitaxiale d'une couche barrière (108-1) à base d'un matériau semi-conducteur fortement dopé n+.

Selon un aspect particulier de l'invention, l'étape de réaliser une couche barrière de surface de grande bande interdite comprend une étape de croissance épitaxiale d'une couche barrière (108-2) à base d'un matériau semi-conducteur non intentionnellement dopé, et une étape de dopage localisé (110) de type n+ de la couche barrière non intentionnellement dopée.

Selon un aspect particulier de l'invention, l'étape de dopage localisé n+ est réalisé par implantation ou par diffusion.

Dans un mode de réalisation, les semi-conducteurs utilisés par le procédé de l'invention sont les semi-conducteurs de type III-V.

Dans un mode de réalisation, les semi-conducteurs de type III-V utilisés par le procédé de l'invention sont les semi-conducteurs InGaAs sur substrat InP.

Dans un mode de réalisation, les semi-conducteurs de type III-V utilisés par le procédé de l'invention sont les semi-conducteurs InGaAsSb sur substrat GaSb ou de super-réseau de la famille InGaAs / GaAsSb sur substrat InP.

L'invention a aussi pour objet une photodiode obtenue selon le procédé de l'invention dans toutes ses variantes de réalisation.

L'invention a aussi pour objet un composant optoélectronique comprenant au moins une photodiode, ce composant étant obtenu selon le procédé de l'invention dans toutes ses variantes de réalisation.

### Brève Description des Dessins

D'autres caractéristiques et avantages de la présente invention apparaîtront mieux à la lecture de la description qui suit en relation aux dessins suivants :
Les figures 1a et 1b illustrent respectivement une structure connue d'une diode PIN planaire en matériau semi-conducteur InGaAs sur substrat InP, et un diagramme de bande d'une telle diode PIN;
La figure 2 illustre une structure connue de bande d'une photodiode UTC ;
La figure 3 illustre un exemple de configuration mesa connue pour une photodiode UTC ;
La figure 4 illustre une structure de bande connue d'une photodiode à avalanche (APD) avec une zone absorbante en matériau InGaAs non déplétée ou à dopage gradué ;
La figure 5 illustre un mode de pixellisation par diffusion localisée d'un dopant de type p ;
La figure 6 illustre un mode de pixellisation par mésa avec un dopage de type p+ en cours de croissance;
La figure 7 illustre une approche de pixellisation issue de technologies existantes où des matrices de photodiodes de type UTC ou APD seraient réalisées pour limiter le courant d'obscurité ;
La figure 8 illustre un empilement de couches semi-conductrices dans un mode de réalisation du procédé de fabrication d'un composant optoélectronique de l'invention, où contrairement à l'état de l'art connu, la couche buffer sur le substrat sur laquelle est déposée l'hétérostructure n'est pas de type N ;
Les figures 9a-10a et 9b-10b illustrent pour chaque variante de réalisation du procédé de l'invention, une couche barrière de surface fortement dopée et de grande bande interdite ;
Les figures 11a et 11b illustrent pour chaque variante de réalisation du procédé de l'invention, une opération de métallisation pour prise de contact de type N ;
Les figures 12a et 12b illustrent pour chaque variante de réalisation du procédé de l'invention, une opération de gravure pour séparer des pixels ;
[Fig.13a] [Fig.13b] illustrent pour chaque variante de réalisation du procédé de l'invention, une opération de gravure pour prise de contact de type P ;
[Fig.14a] [Fig.14b] illustrent pour chaque variante de réalisation, une opération de passivation et d'interconnexion pour le contact commun P ;
[Fig.15a] [Fig.15b] illustrent une variante de réalisation d'une opération de passivation et d'interconnexion ;
[Fig.16a] [Fig.16b] illustrent une autre variante de réalisation d'une opération de passivation et d'interconnexion ;
La figure 17 illustre les étapes principales du procédé de l'invention.

### Description détaillée de l'invention

Les références dans les différentes figures sont conservées identiques quand elles désignent des éléments identiques ou similaires.

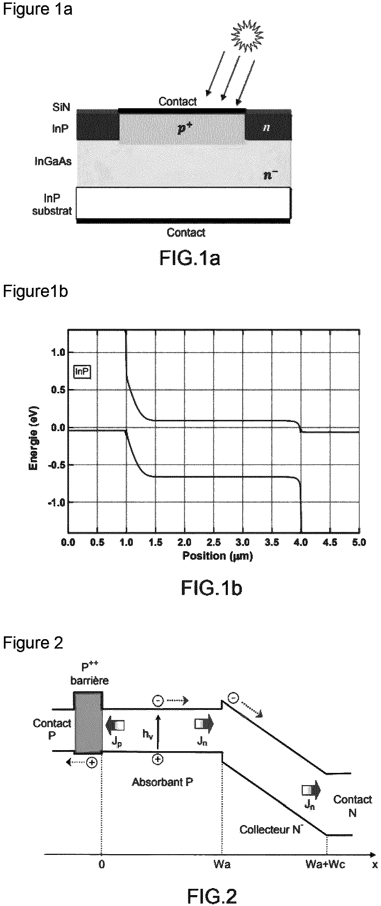

Il est d'abord fait quelques rappels sur les diodes et en particulier les photodiodes en support des figures 1 à 4.

Une photodiode est un composant optoélectronique ayant la capacité de détecter un rayonnement du domaine optique et de le transformer en signal électrique. Une photodiode est une diode à semi-conducteur dans laquelle un rayonnement lumineux incident provoque une variation de l'intensité. Les photodiodes sont généralement utilisées en tant que matrices de photodiodes pour des applications d'observation de la terre et des applications de localisation et poursuite d'un satellite émetteur ou d'une station sol.

Une structure de diode connue est présentée sur la figure 1a qui montre un empilement typique d'une diode PIN planaire en matériau semi-conducteur InGaAs sur substrat InP, constituée d'une zone centrale non-dopée dite intrinsèque I, intercalée entre deux zones dopées P et N. En plus des couches dopées P+ et N+ typiques d'une diode, la diode PIN possède une zone centrale I dont le dopage est très inférieur. Cette zone agit alors comme un semi-conducteur intrinsèque, c'est-à-dire non dopé.

La figure 1b illustre un diagramme de bande d'un exemple d'une diode PIN sur substrat InP pour des bandes InGaAS / InP. Le champ électrique interne correspond à la dérivée des bandes de conduction et de valence. Ici, la zone active en InGaAs d'épaisseur 3 µm se situe entre la fenêtre InP de type p (abscisse x = 1 µm) et le contact InP de type n (à partir de x = 4 µm). La zone active présente une zone désertée, de x = 1 µm à x = 1,5 µm qui est fonction du dopage, et une zone neutre allant de x = 1,5 µm jusqu'à x = 4 µm.

Les structures de diodes PIN sont connues pour présenter un champ électrique important dans le matériau InGaAs déserté, et pour être très vite dégradée sous irradiation.

Concernant le cas des hétérojonctions (une hétérojonction est une jonction entre deux semi-conducteurs dont les bandes interdites - « gap » en langue anglaise - sont différentes, car les deux semi-conducteurs sont différents ou parce que la jonction se fait entre un métal et un semi-conducteur), il ressort que, dans le cas des petits gaps utilisés pour l'infrarouge, les seules approches pour limiter la génération des courants d'obscurité induits, consistent à réduire la polarisation des diodes de manière à limiter le champ électrique dans la jonction, et à abaisser la température.

### Rappel sur les familles de photodiodes :

Il existe deux grandes familles de photodiodes rapides, les photodiodes de type UTC pour « Uni-Traveling Carrier » selon l'anglicisme consacré ou photodiode à porteuse unidirectionnelle, et les photodiodes de type APD pour « Avalanche PhotoDiode » selon l'anglicisme consacré ou photodiode à avalanche.

La photodiode UTC est largement développée pour sa linéarité par rapport au flux et sa rapidité. Celle-ci est permise car le transport électronique est uniquement déterminé par les électrons. En effet, les électrons porteurs minoritaires dans la zone absorbante de type p diffuse vers une zone collectrice en matériau InP intrinsèquement non dopé, où ils sont accélérés et collectés du côté du contact de type N. Les trous moins mobiles sont quant à eux instantanément collectés du côté du contact de type P. Ils ne dimensionnent pas le transport électrique, ce qui permet d'optimiser la tenue des structures aux forts flux optiques, tout en conservant de bonnes performances fréquentielles (moyennant le contrôle d'autres paramètres comme la capacité électrique). L'autre avantage de cette structure est de limiter le courant d'obscurité dans la couche InGaAs en l'absence de champ électrique.

La figure 2 illustre une structure de bande d'une photodiode UTC, avec de gauche à droite :
- un contact P typiquement en matériau InGaAs fortement dopé p ;
- une barrière pour bloquer les électrons P⁺⁺, fortement dopée p ;
- une zone active en matériau InGaAs de type p. Ceci suppose un dopage en cours de croissance et non par diffusion. Un tel dopage peut être aussi gradué pour optimiser le transport électronique des électrons et équilibrer les temps de transit des deux types de porteurs. Si le courant d'obscurité reste légèrement dégradé dans le mode de réalisation actuel, il est attendu en version matricielle une optimisation de la MTF (« Modulation Transfer Function » en anglais) ;
- plusieurs couches d'adaptation pour assurer la continuité de la bande de conduction vers le collecteur N-; et
- une zone collectrice où règne le plus fort champ électrique qui permet d'acheminer les électrons vers le contact N+.

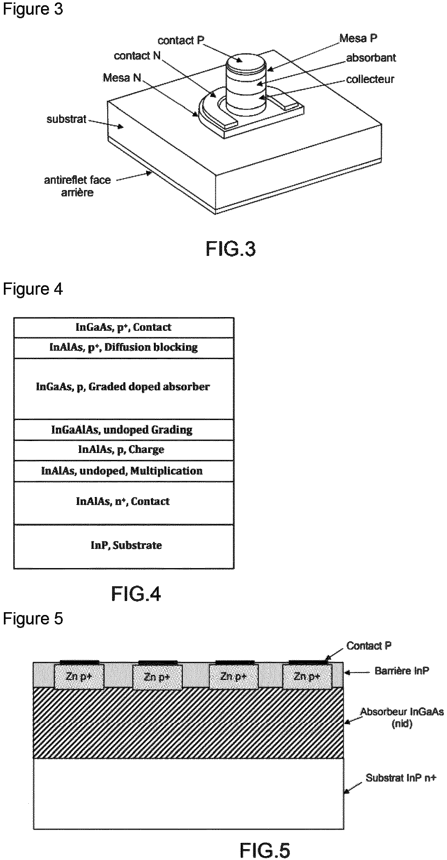

Les diodes UTC sont disponibles en format mono-élément et en configuration mesa. Une configuration mesa obtenue par gravure de la zone active telle que par exemple illustrée sur la figure 3 pour une photodiode à éclairage par la face arrière, n'est pas optimale car le courant d'obscurité est généré à la surface. Ceci rend critique la passivation des flancs de la diode et limite le bilan de portée dans le cas de source lumineuse peu intense.

Une alternative pour la détection des faibles signaux dans le cas de source lumineuse peu intense, peut-être l'utilisation d'une photodiode avalanche (APD) avec une zone absorbante en matériau InGaAs non déplétée ou à dopage gradué telle que décrite par exemple dans l'article de N Li and al. « InGaAs/lnAIAs Avalanche Photodiode with undepleted absorber », Applied Physicq Letters, Vol.82, No.13, pp2175-2177, March 2003, et illustrée sur la figure 4. Les électrons rentrent dans une zone avalanche en InAIAs où ils sont multipliés. Le transport électronique des trous est similaire à celui de la diode UTC dans la zone absorbante. La zone de charge dopée p permet de contrôler finement le champ électrique dans la zone avalanche. L'avantage que l'absorbant ne soit plus déplété par rapport à une diode APD classique est que le courant d'obscurité est plus faible.

Ainsi, selon les connaissances actuelles, les photodiodes UTC et APD à absorbant non déplété ou à dopage gradué sont a priori moins sensibles à l'irradiation. Elles existent en format mesa mais elles sont alors tributaires d'une passivation efficace pour garantir un bon bilan de portée sur des liens optiques.

Elles pourraient exister en technologie diffusée, mais il faudrait alors garantir une isolation électrique entre photodiodes au niveau de la couche collecteur pour les UTC, ou de la zone avalanche pour les APD.

La figure 5 illustre un mode de pixellisation par diffusion localisée d'un dopant de type p : par exemple le zinc Zn dans le cas d'une zone active InGaAs de type n ou nid (i.e. non intentionnellement dopé). Ce mode de fabrication est standard pour les imageurs InGaAs et permet de s'affranchir de la réalisation de mésas difficiles à passiver et à l'origine de courants d'obscurité importants. Typiquement les technologies existantes utilisent une couche buffer de type N sur le substrat sur laquelle est déposée l'hétérostructure PIN.

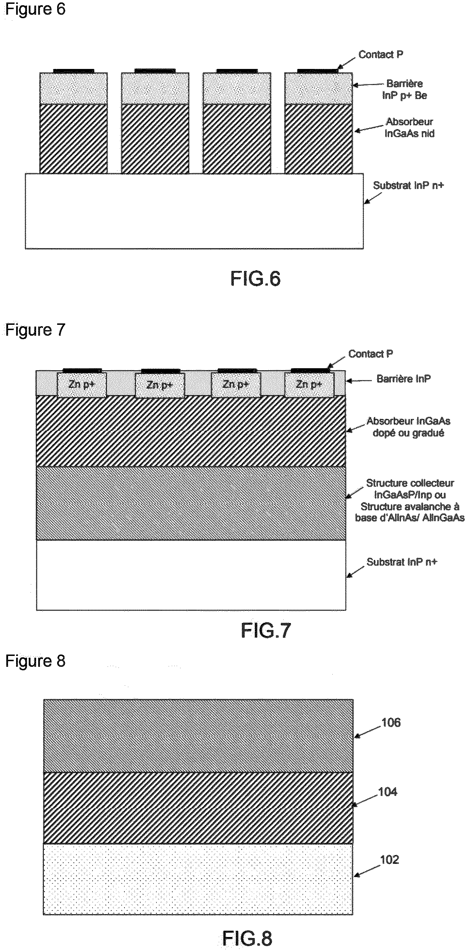

La figure 6 illustre un mode de pixellisation par mésa avec un dopage de type p+ en cours de croissance (Be). Les mésas mettent à nu la zone active en particulier au niveau de la zone désertée. C'est ici que la génération de courants d'obscurité peut devenir dramatique.

La figure 7 illustre une approche de pixellisation issue de technologies existantes où les matrices de photodiodes de type UTC ou APD seraient réalisées avec pour but de limiter le courant d'obscurité. Cela consisterait en une diffusion Zn dans le cas d'une zone active InGaAs de type p. Cette zone active est placée au-dessus du grand gap dans lequel se déploie l'essentiel du champ électrique, que ce soit une structure de type UTC ou de type APD.

Comme indiqué, pour pallier aux inconvénients des technologies connues de fabrication de composants optoélectroniques, et pour répondre au besoin d'applications spécifiques, comme celle de poursuite entre satellites par exemple, le procédé de fabrication de l'invention permet l'obtention de structures de photodiodes UTC ou APD à hétérojonction avec absorbant non déserté ou à dopage gradué.

L'avantage de ces structures est que le champ électrique de collection des électrons se situe en dehors de la zone d'absorption non désertée ou à dopage gradué, ce qui permet de bénéficier d'une plus forte robustesse vis-à-vis de l'irradiation.

En déplaçant le champ électrique de collection des électrons dans une couche de plus large bande interdite et/ou plus facile à passiver, les courants d'obscurité vont être plus faibles, en particulier ceux générés dans la zone absorbante.

Un autre avantage découlant des structures obtenues où les couches collecteurs ou avalanche et le contact N apparaissent en surface (permettant de collecter directement les électrons porteurs minoritaires via un circuit de lecture ROIC en version matricielle), est de permettre de bénéficier de composants à fortes bandes passantes (plus de 10 à 20 GHz) pour des applications spécifiques, telles que les applications de poursuite entre satellites permettant de fusionner les fonctions de poursuite et de détection rapide.

La figure 8 illustre des opérations initiales de croissance épitaxiale pour réaliser un empilement de couches semi-conductrices (102, 104, 106, 108) à partir duquel un composant optoélectronique selon l'invention est réalisé.

Comme représenté sur la figure 8, une couche d'absorption 104 destinée à former la zone d'absorption lumineuse des photodiodes, est réalisée en matériau InGaAs sur un substrat semi-conducteur 102 en matériau InP.

Dans un mode de réalisation préférentielle tel que décrit, les semi-conducteurs utilisés par le procédé de l'invention sont les semi-conducteurs InGaAs sur substrat InP.

Des variantes peuvent être déclinées pour d'autres matériaux de type III-V où le matériau de plus petite largeur de bande interdite est le plus sensible (les super-réseaux de la famille InGaAs / GaAsSb ou quaternaire InGaAsSb).

Dans une variante de réalisation, le substrat 102 qui sert de support pour la croissance épitaxiale de la couche absorbeur 104, peut présenter une partie supérieure dopée p+. L'épaisseur de la partie supérieure dopée p+ est dans une plage allant de 100nm à plusieurs microns, et le dopage est supérieur à 10¹⁷ cm⁻³. Cette couche permet de constituer un « buffer » de l'épitaxie si l'on conserve un substrat de type n ou de type semi-isolant. En effet, cette solution mais avec un substrat InP de type p (comme dans l'art antérieur) aurait une moindre qualité et pas de transparence.

Le matériau semi-conducteur de la couche absorbeur 104 est dopé p, et selon différents modes de réalisation, le dopage est réalisé de manière uniforme ou il est gradué. Le dopage est réalisé par des moyens connus appropriés tels que l'introduction d'un dopant Carbone (C) ou Beryllium (Be).

Une couche faiblement dopée et de grande bande interdite 106 est réalisée sur la couche d'absorption 104, permettant de collecter les électrons. Cette couche 106 sera soumise au plus fort champ électrique présent lors du fonctionnement du composant qui sera fabriqué. L'épaisseur de la couche faiblement dopée et de grande bande interdite est dans une plage allant de quelques dizaines de nanomètres (nm) à quelques centaines de nm, en fonction des propriétés visées (tension d'avalanche, capacité électrique...).

Dans un mode de réalisation, l'étape de réalisation de la couche faiblement dopée et de grande bande interdite consiste à créer une zone collectrice, si la photodiode du composant optoélectronique à réaliser est une photodiode UTC. Dans un mode de réalisation, la zone collectrice est à base de matériau InGaAsP/InP.

Dans un mode de réalisation, l'étape de réalisation de la couche faiblement dopée et de grande bande interdite consiste à créer une zone avalanche si la photodiode du composant optoélectronique à réaliser est une photodiode APD. Dans un mode de réalisation, la zone avalanche est à base de matériau AlInAs/AlInGaAs.

Dans d'autres variantes de réalisation, les zones d'avalanche des photodiodes APDs peuvent être dans l'un des matériaux suivants : InP, AlInAs, AlGaAsSb ou AlInAsSb.

Dans d'autres variantes de réalisation, les collecteurs des photodiodes UTCs peuvent être réalisés à partir de l'un des matériaux suivants : InP ou AlInAs.

Par ailleurs, une très grande variété de couche d'adaptation peut être utilisée.

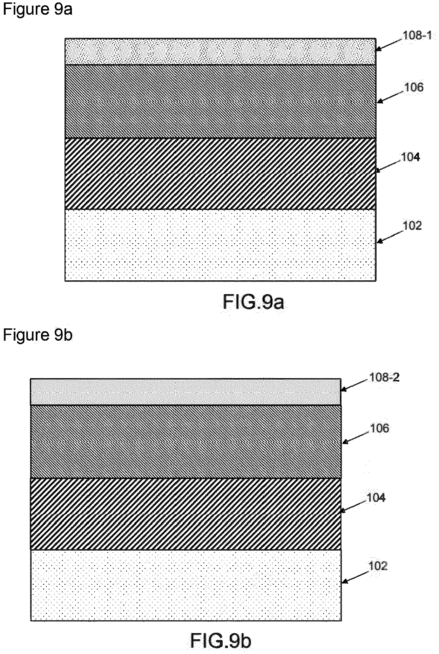

Avantageusement, le composant optoélectronique obtenu par le procédé de l'invention, peut être réalisé selon deux versions technologiques : une version dite 'semi-mesa' illustrée par les figures 9a à 16a, et une version dite 'jonction diffusée' illustrée par les figures 9b à 16b.

Les figures 9a et 9b illustrent pour chaque version technologique du procédé de l'invention, la réalisation, au-dessus de la couche faiblement dopée et de grande bande interdite 106, d'une couche barrière de surface de grande bande interdite.

Selon la version semi-mesa de la figure 9a, la couche barrière de surface de grande bande interdite 108-1 est obtenue par une croissance épitaxiale d'une couche barrière en matériau InP, InAlAs, AlAsSb, AlGaAsSb ou AlInAsSb. Dans un mode préférentiel, le matériau est du même type que pour le collecteur.

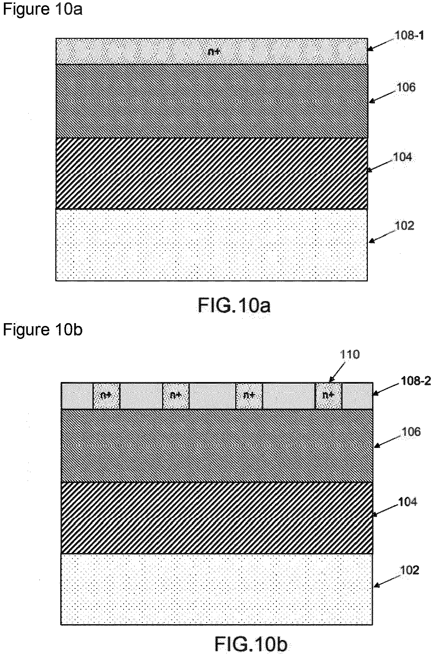

La couche barrière de surface 108-1 de grande bande interdite est fortement dopée n+ (illustré sur la figure 10a) par un dopage > 10¹⁸ cm⁻³.

De manière préférentielle, une couche contact est réalisée pour faciliter le contact ohmique.

Selon la version jonction diffusée de la figure 9b, la couche barrière de surface de grande bande interdite 108-2 est obtenue par une croissance épitaxiale d'une couche barrière d'une épaisseur allant de quelques 100nm à 1µm, en matériau semi-conducteur de type n- ou résiduel n (i.e. nid, non intentionnellement dopé). Dans un mode de réalisation, le matériau de type nid est du InP ou du InAlAs.

L'opération de croissance épitaxiale est suivie selon la figure 10b d'une opération de dopage localisé de type n+, par un dopage > 10¹⁸ cm⁻³, permettant d'obtenir des îlots avec des surfaces locales 110 fortement dopées n+.

Selon différents modes de réalisation, le dopage localisé n+ peut être réalisé par implantation et éventuellement par diffusion de Germanium (Ge) lors de la formation d'un contact allié si la couche barrière 108-2 est suffisamment fine.

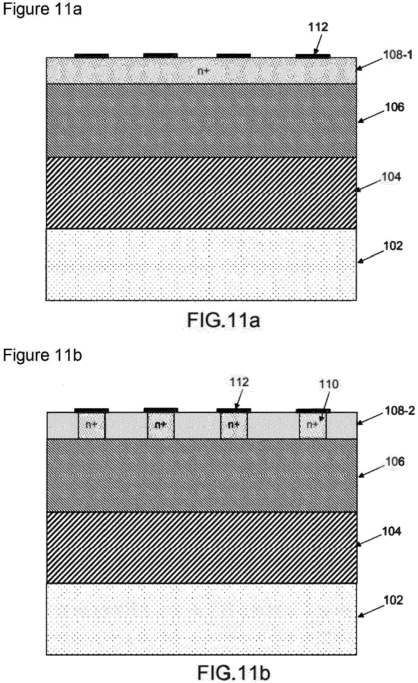

L'opération complète de pixellisation encore désignée comme opération de réticulation correspond à plusieurs opérations qui sont illustrées par les figures 11 à 16. En effet, c'est l'ensemble des opérations soit des figures 11a à 16a, soit des figures 11b à 16b, qui conduit à la séparation spatiale des photo-courants et à leur collection (pixellisation).

Les figures 11a et 11b illustrent pour chaque version technologique du procédé de l'invention, une opération de métallisation 112 des surfaces fortement dopées n+ précédemment obtenues, pour prise de contact(s) de type N.

Dans la variante de la figure 11a, des contacts ohmiques sont obtenus sur la couche barrière 108-1 par des opérations de métallisation connues permettant la réalisation d'un contact ou d'une pluralité de contacts de géométrie prédéfinie. Les espacements entre plots sont minimisés tout en restant compatibles des règles de dessins (« design rules » en anglais) imposés par les méthodes de fabrication.

Dans la variante de la figure 11b, des contacts ohmiques sont obtenus sur chaque surface locale fortement dopée n+ des plots (110) obtenus.

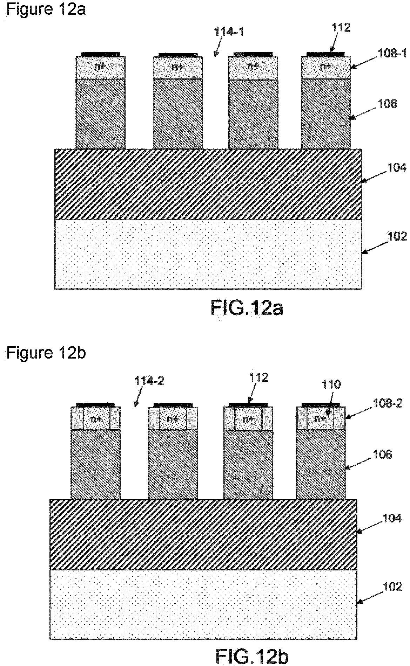

Les figures 12a et 12b illustrent pour chaque version de réalisation du procédé de l'invention, une opération de gravure 114 et de passivation mesa pour obtenir des pixels séparés.

Dans la variante de la figure 12a, la gravure 114-1 est réalisée par des moyens connus appropriés, comme une gravure plasma ICP (« Induced Coupled Plasma » selon l'anglicisme consacré) pour traverser la couche barrière fortement dopée 108-1 et la couche faiblement dopée 106. La gravure est stoppée au niveau de la couche d'absorption 104. Une passivation mesa est ensuite réalisée.

Dans la variante de la figure 12b, la gravure 114-2 est réalisée par des moyens connus appropriés, comme une gravure plasma ICP pour traverser la couche barrière de surface nid 108-2 et la couche faiblement dopée 106. La gravure est stoppée au niveau de la couche d'absorption 104. Une passivation mesa est ensuite réalisée.

Dans une alternative à la deuxième version de réalisation, il peut ne pas être nécessaire de réaliser après la gravure une passivation mesa, s'il est déterminé que la performance en diaphonie des structures UTC ou APD est satisfaisante.

A l'issue de l'opération de gravure et le cas échéant de passivation mesa, le procédé a permis de réaliser des tranchées qui entourent des structures mesa, c'est-à-dire des empilements de couches formant des îlots ohmiques de contact N, reposant sur la couche d'absorption 104, elle-même reposant sur le substrat 102. Il s'agit du contact commun de type n.

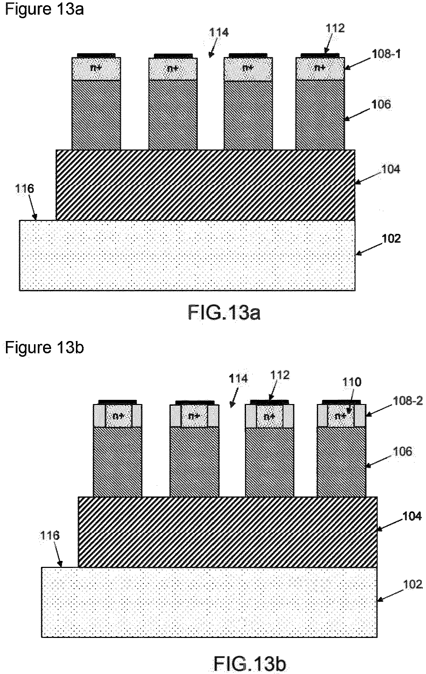

Les figures 13a et 13b illustrent pour chaque version de réalisation du procédé de l'invention, une opération de gravure pour prise de contact commun de type P sur le substrat 102. La gravure 116 est réalisée par des moyens connus appropriés (ICP par exemple) pour traverser la couche d'absorption 104 dans une zone où elle est apparente en surface, et pour être stoppée au niveau de la surface du substrat 102.

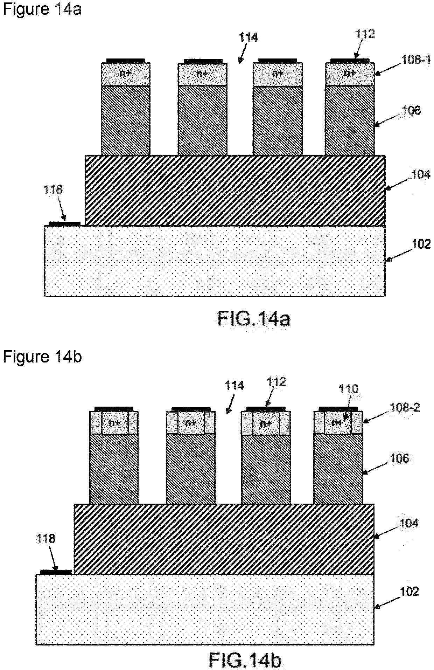

Les figures 14a et 14b illustrent pour chaque version de réalisation, une opération de passivation et d'interconnexion électrique pour le contact commun P. La passivation est un dépôt 118 en matériau de type SiN ou SiOx couvrant les flancs des mésas.

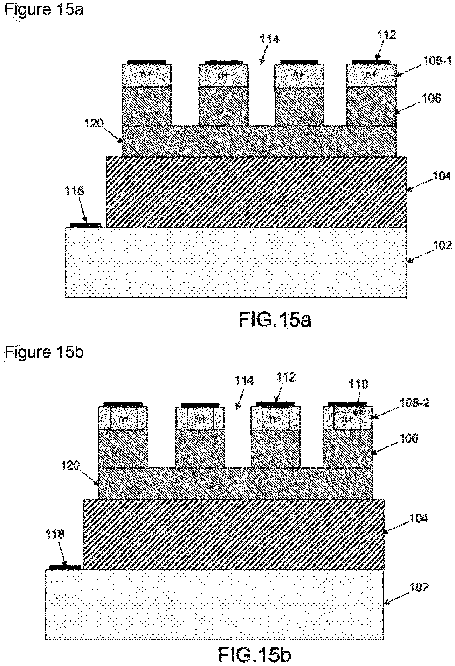

Les figures 15a et 15b illustrent une variante de réalisation d'une opération de passivation et d'interconnexion (120) électrique permettant de ne pas mettre à nu l'absorbeur et limitant la génération de courant d'obscurité.

Une couche de plus grand gap que la zone absorbante doit alors présenter des caractéristiques pour le couple de paramètres (dopage, épaisseur) qui permettent d'écranter les charges de surface.

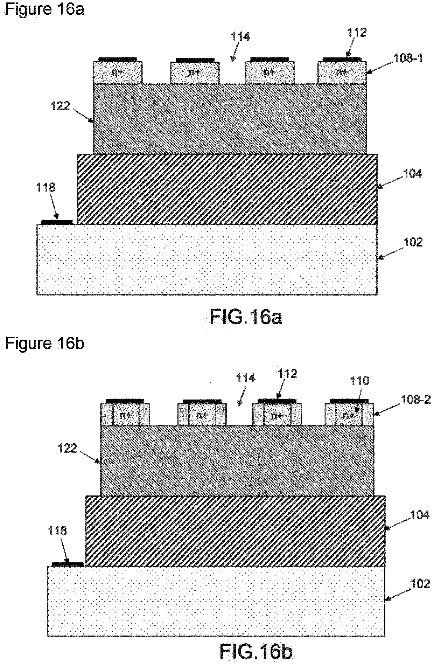

Les figures 16a et 16b illustrent une autre variante de réalisation d'une opération de passivation et d'interconnexion électrique (120) où seul le contact n+ est déserté. Cette solution est viable si la continuité de la couche de collection (UTC) ou d'avalanche (APD) n'engendre pas de diaphonie.

Il a ainsi été décrit deux modes de réalisation du procédé de l'invention permettant de développer des matrices de photodiodes UTC ou APD à absorbant non déserté ou à dopage gradué, de manière à bénéficier d'une plus forte robustesse vis-à-vis de l'irradiation, et à limiter les courants d'obscurité dans la zone absorbante.

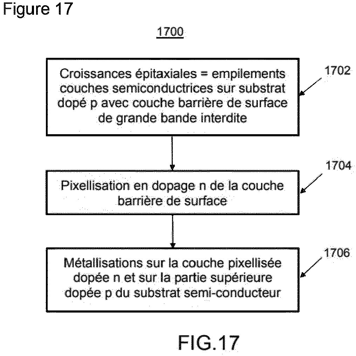

La figure 17 illustre les étapes principales du procédé 1700 de l'invention, détaillées selon les différentes variantes dans les figures 8 à 16.

Ainsi, sous une première étape 1702, il est réalisé à partir d'un substrat semi-conducteur dopé p au moins sur sa partie supérieure, plusieurs croissances épitaxiales pour obtenir un empilement de couches semi-conductrices, l'empilement étant composé au-dessus du substrat (102), d'une couche d'absorption (104) dans un matériau dopé p, puis d'une couche pour collecter des électrons (106) faiblement dopée et de grande bande interdite, et d'une couche barrière de surface (108-1, 108-2) de grande bande interdite.

Sous une seconde étape 1704, il est réalisé une pixellisation en dopage n de la couche barrière de surface de grande bande interdite, la pixellisation comprenant des métallisations (1706) pour créer des contacts électriques (112, 118) pour la ou les photodiode(s), d'une part sur la couche barrière de surface pixellisée dopée n, et d'autre part sur la partie supérieure dopée p du substrat semi-conducteur.

Avantageusement, dans la version technologique de jonction diffusée, la passivation est optimisée car aucune opération de gravure n'est effectuée. Cependant le risque est que le matériau InGaAs non déserté puisse dégrader les performances de MTF et celles du « cross-talk » en version matricielle. L'homme du métier pourra alors graduer légèrement l'absorbant de manière à rendre la collection des électrons plus anisotrope. Toutefois il faudra veiller à limiter la valeur du champ électrique afin de limiter l'augmentation du courant d'obscurité.

Dans la version semi-mesa, la couche barrière n+ dopée par épitaxie est a minima gravée. Suivant les performances de gravure et passivation des structures UTC ou APD, la gravure peut se faire jusqu'à l'absorbant ou non, l'avantage étant de relâcher la contrainte sur la graduation du dopage de l'InGaAs, voire de s'en affranchir.

## Revendications

1. Procédé de fabrication d'un composant optoélectronique comprenant au moins une photodiode, le procédé (1700) comprenant au moins des étapes consistant à :
- réaliser (1702) à partir d'un substrat semi-conducteur dopé p au moins sur sa partie supérieure, plusieurs croissances épitaxiales pour obtenir un empilement de couches semi-conductrices, l'empilement étant composé au-dessus du substrat (102), d'une couche d'absorption (104) dans un matériau dopé p, puis d'une couche pour collecter des électrons (106) faiblement dopée et de grande bande interdite, et d'une couche barrière de surface (108-1, 108-2) de grande bande interdite ; et
- réaliser (1704) une pixellisation à base de dopage de type n au niveau de la couche barrière de surface, la pixellisation comprenant des métallisations (1706) pour créer des contacts électriques (112, 118) pour ladite au moins une photodiode, d'une part sur la couche barrière de surface pixellisée dopée n, et d'autre part sur la partie supérieure dopée p du substrat semi-conducteur.

2. Procédé selon la revendication 1 dans lequel l'étape de réaliser une couche d'absorption (104) comprend une étape de dopage uniforme ou gradué de type p du matériau de ladite couche d'absorption.

3. Procédé selon la revendication 1 ou 2 dans lequel l'étape de réaliser une couche pour collecter des électrons (106) consiste à réaliser une zone collectrice si ladite au moins une photodiode est une photodiode UTC.

4. Procédé selon la revendication 1 ou 2 dans lequel l'étape de réaliser une couche pour collecter des électrons (106) consiste à réaliser une zone avalanche si ladite au moins une photodiode est une photodiode APD.

5. Procédé selon l'une quelconque des revendications 1 à 4 dans lequel l'étape de réaliser une couche barrière de surface de grande bande interdite consiste en une croissance épitaxiale d'une couche barrière (108-1) à base d'un matériau semi-conducteur fortement dopé n+.

6. Procédé selon l'une quelconque des revendications 1 à 4 dans lequel l'étape de réaliser une couche barrière de surface de grande bande interdite comprend une étape de croissance épitaxiale d'une couche barrière (108-2) à base d'un matériau semi-conducteur non intentionnellement dopé, et une étape de dopage localisé (110) de type n+ de la couche barrière non intentionnellement dopée.

7. Procédé selon la revendication 6 dans lequel l'étape de dopage localisé n+ est réalisé par implantation ou par diffusion.

8. Procédé selon l'une quelconque des revendications précédentes dans lequel les semi-conducteurs utilisés par le procédé de l'invention sont les semi-conducteurs de type III-V.

9. Procédé selon la revendication précédente dans lequel les semi-conducteurs de type III-V utilisés par le procédé de l'invention sont les semi-conducteurs InGaAs sur substrat InP.

10. Procédé selon la revendication précédente dans lequel les semi-conducteurs de type III-V utilisés par le procédé de l'invention sont les semi-conducteurs InGaAsSb sur substrat GaSb ou de super-réseau de la famille InGaAs / GaAsSb sur substrat InP.

11. Photodiode obtenue par un procédé de fabrication comprenant au moins les étapes de l'une quelconque des revendications 1 à 10.

12. Composant optoélectronique comprenant au moins une photodiode selon la revendication 11.
